# EUROPÄISCHE PATENTANMELDUNG

(11) **EP 1 511 136 A1**
(43) Veröffentlichungstag der Anmeldung: **02.03.2005**
(21) Anmeldenummer: 04015833.9
(22) Anmeldetag: 06.07.2004
(51) Int. Cl.: H01S 5/0683, G01S 17/08, H04B 10/155

(54) **Elektromagnetische Sendeanordnung**

(30) Priorität: 01.09.2003 DE 10340167
(71) Anmelder: ROBERT BOSCH GMBH, 70442 Stuttgart (DE)
(72) Erfinder: Pidoux, Raymond, CH-1313 Ferreyres (CH)

(57) **Zusammenfassung**

Die Erfindung geht aus von einer elektromagnetischen Sendeanordnung mit einer Laserdiode (10) sowie Ansteuermitteln zum Ansteuern der Laserdiode (10).

Es wird vorgeschlagen, dass die Ansteuermittel ausgebildet sind, die Laserdiode (10) unterhalb einer Stromschwelle (I_{TH}) zu betreiben, bei deren Überschreiten die Laserdiode (10) in einen Bereich induzierter Emission von elektromagnetischer Strahlung arbeitet, so dass die Laserdiode (10) im Bereich spontaner Emission von elektromagnetischer Strahlung betreibbar ist.

## Beschreibung

### Stand der Technik

Die Erfindung geht aus von einer elektromagnetischen Sendeanordnung nach dem Oberbegriff des Anspruchs 1.

Es ist bekannt, bei Entfernungsmessgeräten Licht emittierende Dioden (LED) als Sendelichtquelle zu verwenden. Außerdem ist bereits vorgeschlagen worden, Laserdioden als Sendelichtquelle bei Entfernungsmessgeräten einzusetzen. Ein solches Laser-Entfernungsmessgerät ist beispielsweise aus der Offenlegungsschrift DE 43 33 113 A1 bekannt.

### Vorteile der Erfindung

Die Erfindung geht aus von einer elektromagnetischen Sendeanordnung mit einer Laserdiode sowie Ansteuermitteln zum Ansteuern der Laserdiode.

Es wird vorgeschlagen, dass die Ansteuermittel ausgebildet sind, die Laserdiode unterhalb einer Stromschwelle zu betreiben, bei deren Überschreiten die Laserdiode in einen Bereich induzierter Emission von elektromagnetischer Strahlung arbeitet, so dass die Laserdiode im Bereich spontaner Emission von elektromagnetischer Strahlung betreibbar ist. Dadurch kann auf eine aufwändige und teure Ansteuerung der Laserdiode verzichtet werden. Gleichzeitig wird ausgenutzt, dass Laserdioden durch ihren speziellen Resonatoraufbau auch in einem LED-Betriebsbereich mit spontaner Emission von Strahlung eine numerische Apertur und eine kleine Austrittsfläche des Sendestrahls aufweisen, die nahezu dieselbe vorteilhafte geringe Größe haben wie im eigentlichen Laser-Betriebsbereich. Dadurch kann die Laserdiode wie eine LED eingesetzt werden, ohne die nachteiligen Eigenschaften einer LED, wie sehr große Austrittsfläche der Strahlung, die ein Kollimieren des Sendestrahls erschwert, und deren nachteilige inhomogene Intensitätsverteilung, die von einer bauartbedingten Elektrode im Zentrum der Austrittsfläche herrührt, in Kauf nehmen zu müssen. Zusätzlich kann eine sehr preiswerte Laserdiode mit relativ niedriger Güte eingesetzt werden, da deren Laser-Betriebsbereich nicht von Bedeutung ist. Die erfindungsgemäße Sendeanordnung weist dagegen einen gebündelten Sendestrahl mit einer homogenen Intensitätsverteilung auf. Dadurch kann eine preiswerte Sendequelle geschaffen werden. Vorzugsweise liegt die Strahlung im sichtbaren Bereich, jedoch ist auch, abhängig von den verwendeten Halbleitermaterialien, Strahlung im Sichtbaren oder Ultravioletten denkbar.

Umfassen die Ansteuermittel einen ersten Verstärker zum Ansteuern der Laserdiode, kann dieser sehr einfach und entsprechend preiswert ausgeführt sein.

Umfassen die Ansteuermittel eine Modulationssignalquelle, kann das Modulationssignal einfach in dem ersten Verstärker zugemischt werden. Dadurch kann ein modulierter Sendestrahl der Laserdiode erzeugt werden. Dies ist vorteilhaft für einen Einsatz bei Entfernungsmessgeräten.

Umfassen die Ansteuermittel eine Photodiode, kann diese von der Laserdiode ausgesandte elektromagnetische Strahlung empfangen.

Vorzugsweise bildet die Photodiode eine Stromquelle für die Laserdiode. Abhängig von dem Strom kann die Laserdiode angesteuert werden.

Bevorzugt bildet die Photodiode mit der Laserdiode eine Rückkopplungsanordnung. Ein Ist-Signal der Photodiode kann den ersten Verstärker steuern. Der von der Photodiode gelieferte Ausgangsstrom ist klein genug, so dass stets der geeignete Strom in die Laserdiode eingespeist wird, um diese unterhalb der Stromschwelle zum Laser-Betriebsbereich bleibt und daher stets im LED-Betriebsbereich arbeitet.

Weist die Rückkopplungsanordnung einen Tiefpassfilter auf, der zwischen die Photodiode und einen ersten Eingang des ersten Verstärkers geschaltet ist, können Störungen und ein Rauschen des Ausgangssignals der Photodiode ohne großen Aufwand eliminiert werden.

Ist die Photodiode mit einem Eingang eines Referenzverstärkers verbunden, kann aus dem Stromsignal der Photodiode ein Spannungs-Referenzsignal für eine etwaige Empfänger- und/oder Auswerteschaltung, etwa für eine Laufzeitmessung des Sendestrahls, erzeugt werden.

Ist eine Strahlungsempfängeranordnung vorgesehen, welche an einem Objekt reflektierte Strahlung der Laserdiode empfängt, kann die Sendeanordnung in einem Entfernungsmessgerät eingesetzt werden.

Ist der Strahlungsempfängeranordnung ein Referenzsignal der Referenzverstärker zuführbar, kann diese abhängig von der Modulation der Laserdiode gesteuert werden.

Vorteilhafterweise findet die Sendeanordnung in einer Handwerkzeugmaschine Verwendung. Bei einer Bohrmaschine, insbesondere einem Bohrhammer, kann eine Entfernung der Sendeanordnung zu einer mit einer Bohrung zu versehenden Fläche vermessen und hierdurch die momentane Tiefe der Bohrung bestimmt werden.

Günstig ist eine Verwendung der Sendeanordnung in einem Entfernungsmessgerät. Es ist eine preiswerte Möglichkeit zur Entfernungsmessung möglich.

Günstig ist weiterhin die Verwendung der Sendelichtanordnung in einem Laser-Zeigergerät oder einer Lichtschranke.

### Zeichnung

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.
Es zeigen:
- Fig. 1: eine Kennlinie einer optischen Ausgangsleistung einer Laserdiode als Funktion eines der Laserdiode zugeführten elektrischen Stroms,
- Fig. 2: ein schematisches Schaltbild einer Sendeanordnung für ein Entfernungsmessgerät und
- Fig. 3: ein schematisches Schaltbild einer weiteren Sendeanordnung.

### Beschreibung der Ausführungsbeispiele

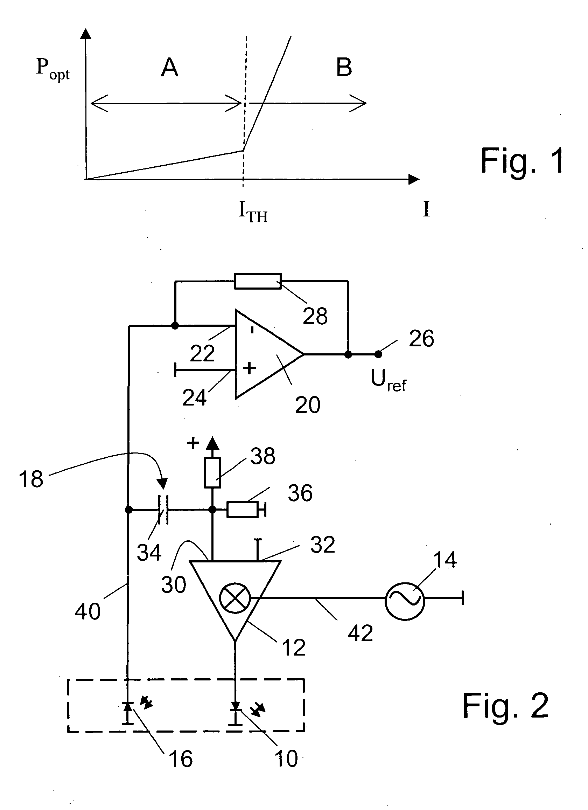

Fig. 1 zeigt eine typische Kennlinie einer Laserdiode, wobei eine optische Ausgangsleistung Pₒₚₜ gegen einen in die Laserdiode eingespeisten Strom I aufgetragen ist. Die Kennlinie steigt linear mit dem Strom I an und zeigt zwei Kennlinienbereiche A, B mit unterschiedlichen Steigungen, die unterschiedlichen Betriebsbereiche charakterisieren. Oberhalb einer Stromschwelle I_{TH} liegt im Kennlinienbereich B der normale Laser-Betriebsbereich der Laserdiode, in dem durch Erzeugung einer Besetzungsinversion der Ladungsträger im Halbleitermaterial der Laserdiode eine induzierte Emission von elektromagnetischer Strahlung stattfindet und der dem üblichen Betriebsmodus der Laserdiode entspricht. Die Steigung der Geraden für einen Strom I oberhalb der Stromschwelle I_{TH} ist ein Maß für die Güte der Laserdiode. Unterhalb der Stromschwelle I_{TH} im Kennlinienbereich A verhält sich die Laserdiode dagegen wie eine übliche LED und zeigt eine spontane Emission von elektromagnetischer Strahlung. Dieser LED-Betriebsbereich entspricht dem Betriebsbereich der Laserdiode in der erfindungsgemäßen Sendeanordnung.

Fig. 2 zeigt ein schematisches Schaltbild einer bevorzugten elektromagnetischen Sendeanordnung, wie sie beispielsweise in einem Entfernungsmessgerät eingesetzt werden kann. Zum Ansteuern der Laserdiode 10 ist ein erster Verstärker 12 vorgesehen. Dieser steuert die Laserdiode 10 bevorzugt stets unterhalb einer Stromschwelle I_{TH} an, bei deren Überschreiten die Laserdiode 10 in einen Bereich induzierter Emission von elektromagnetischer Strahlung arbeitet, so dass die Laserdiode 10 im Bereich spontaner Emission von elektromagnetischer Strahlung, vorzugsweise sichtbaren Lichts, betreibbar ist.

Weiterhin ist zum Ansteuern der Laserdiode 10 eine Modulationssignalquelle 14 vorgesehen. Diese leitet ein Modulationssignal über eine Leitung 42 zum ersten Verstärker 12, in dem das Modulationssignal zu einem Ansteuersignal der Laserdiode 10 zugeführt wird, was durch ein Mischersymbol angedeutet ist.

Eine Photodiode 16 ist benachbart zur Laserdiode 10 angeordnet und empfängt direkt oder indirekt elektromagnetische Strahlung, die von der Laserdiode 10 ausgesandt wird. Die Photodiode 16 wird dabei leitend und gibt einen elektrischen Strom ab, der über eine Leitung 40 teilweise über einen üblichen Tiefpassfilter 18, der einen Kondensator 34 und einen Widerstand 36 umfasst, zu einem ersten Eingang 30 des ersten Verstärkers 12 geleitet wird und teilweise zu einem zweiten Verstärker 20 mit einem ersten Widerstand 28. Der zweite Eingang 32 des ersten Verstärkers 12 liegt auf Masse.

Die Photodiode 16 bildet mit der Laserdiode 10 eine Rückkopplungs- oder Regelungsanordnung zur Regelung des Stroms der Laserdiode 10. Je stärker die Laserdiode 10 strahlt, desto stärker wird das von der Photodiode 16 beeinflusste Eingangssignal am ersten Eingang 30, das bei geeigneter Wahl der Widerstände 36, 38 und des Potentialniveaus am Widerstand 38 den Strom der Laserdiode 10 dämpft. Zusammen mit dem dritten Widerstand 38, der mit dem zweiten Widerstand 36 einen Spannungsteiler bildet, kann ein Arbeitspunkt des ersten Verstärkers 12 voreingestellt und durch die Rückkopplungsanordnung geregelt werden.

Der zweite Verstärker 20, mit dessen erstem Eingang 22 die Photodiode 16 verbunden ist, bildet einen Referenzverstärker, an dessen Ausgang 26 ein Referenzsignal U_{ref} entnommen werden kann. Das Referenzsignal U_{ref} entspricht hierbei dem von der Laserdiode 10 ausgesandten Lichtsignal.

Der zweite Eingang 24 liegt auf Masse. Im Ausführungsbeispiel stellt der zweite Verstärker 20 einen Strom-Spannungswandler dar, wie er mit üblicherweise einer Photodiode 16 eingesetzt wird. Die Ausgangsspannung ist abhängig von dem ersten Widerstand 28, der zwischen dem invertierenden ersten Eingang 22 und dem Ausgang 26 liegt. Das Referenzsignal U_{ref} kann zum Ansteuern einer nicht dargestellten Strahlungsempfängeranordnung verwendet werden, welche an einem Objekt reflektierte elektromagnetische Strahlung der Laserdiode 10 empfängt und beispielsweise zur Laufzeitmessung in einem Entfernungsmessgerät eingesetzt wird.

Eine Dimensionierung der elektrischen Komponenten, wie Widerstände 28, 36, 38, Kapazitäten 34, Spannungsteiler, Verstärker 12, 20 und dergleichen, wird der Fachmann entsprechend der erwünschten Eigenschaften sinnvoll vornehmen.

Bauartbedingt sendet die Laserdiode 10 einen kollimierten Strahl elektromagnetischer Strahlung aus, der beispielsweise als Entfernungsmesssignal für ein Entfernungsmessgerät oder für eine Bohrmaschine oder einen Bohrhammer verwendet werden kann, um eine Bohrtiefe anzuzeigen oder einzustellen. Alternativ kann der Strahl ohne Entfernungsmessfunktion in einem Laser-Zeigergerät oder in einer Lichtschranke verwendet werden.

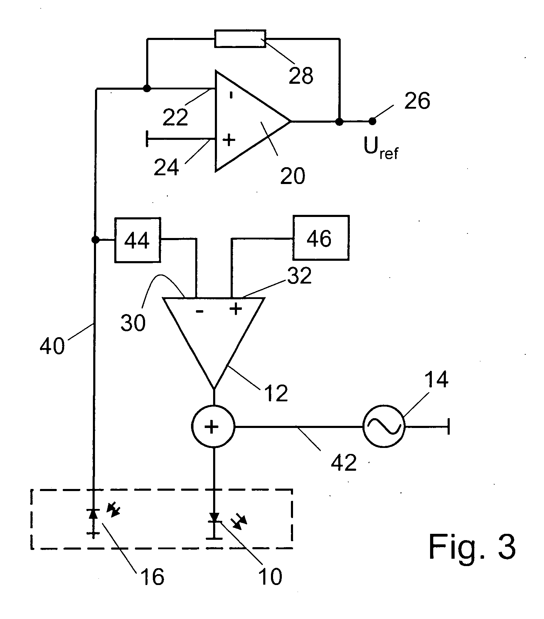

Eine weitere schematische Darstellung einer gegenüber Fig. 2 vereinfachten Schaltung zeigt Fig. 3. Der Tiefpassfilter 18 aus Fig. 2 ist durch einen beliebigen, dem Fachmann geeignet erscheinenden Tiefpassfilter 44 ersetzt und der zweite Eingang 32 des ersten Verstärkers 12 ist mit einer Referenzspannungsquelle 46 verbunden, die auf ein geeignetes Potential eingestellt werden kann. Der Mischer im ersten Verstärker 12 entfällt, wobei das Signal von der Modulationssignalquelle 14 auf das Signal des ersten Verstärkers einfach aufaddiert wird. Das Wirkprinzip der vereinfachten Schaltung entspricht dem Wirkprinzip der Schaltung aus Fig. 2.

Die Laserdiode 10 arbeitet im LED-Betrieb sehr stabil und ist einfach zu betreiben. Daher kann in einer weiteren in den Figuren nicht gezeigten Vereinfachung auf die Rückkopplungsoder Regelungsanordnung zur Regelung des Stroms der Laserdiode 10 verzichtet werden. Dann kann der Tiefpassfilter 18, 44 und die Rückkopplung zum ersten Verstärker 12 entfallen. Bei einem Betrieb ohne Entfernungsmessung kann auch die Photodiode 16, die Anordnung um den zweiten Verstärker 20, die Erzeugung des Referenzsignals und die Modulationssignalquelle 14 entfallen. Die Laserdiode 10 kann dann so betrieben werden, dass sie im LED-Betriebsbereich konstant einen Sendestrahl sendet. Die Laserdiode 10 wird von einer Stromquelle versorgt und vom ersten Verstärker 12 angesteuert.

### Bezugszeichen

- 10: Laserdiode
- 12: erster Verstärker
- 14: Modulationssignalquelle
- 16: Photodiode
- 18: Tiefpassfilter
- 20: Referenzverstärker
- 22: erster Eingang Referenzverstärker
- 24: zweiter Eingang Referenzverstärker
- 26: Ausgang Referenzverstärker
- 28: erster Widerstand
- 30: erster Eingang
- 32: zweiter Eingang
- 34: Kondensator
- 36: zweiter Widerstand
- 38: dritter Widerstand
- 40: Leitung
- 42: Leitung
- 44: Tiefpassfilter
- 46: Referenzspannungsquelle

## Patentansprüche

1. Elektromagnetische Sendeanordnung mit einer Laserdiode (10) sowie Ansteuermitteln zum Ansteuern der Laserdiode (10), **dadurch gekennzeichnet, dass** die Ansteuermittel ausgebildet sind, die Laserdiode (10) unterhalb einer Stromschwelle (I_{TH}) zu betreiben, bei deren Überschreiten die Laserdiode (10) in einen Bereich induzierter Emission von elektromagnetischer Strahlung arbeitet, so dass die Laserdiode (10) im Bereich spontaner Emission von elektromagnetischer Strahlung betreibbar ist.

2. Sendeanordnung nach Anspruch 1, **dadurch gekennzeichnet, dass** die Ansteuermittel einen ersten Verstärker (12) zum Ansteuern der Laserdiode (10) umfassen.

3. Sendeanordnung nach Anspruch 1 oder 2, **dadurch gekennzeichnet, dass** die Ansteuermittel eine Modulationssignalquelle (14) umfassen.

4. Sendeanordnung nach einem der vorhergehenden Ansprüche, **dadurch gekennzeichnet, dass** die Ansteuermittel eine Photodiode (16) umfassen.

5. Sendeanordnung nach Anspruch 4, **dadurch gekennzeichnet, dass** die Photodiode (16) eine Stromquelle zur Versorgung der Laserdiode (10) bildet.

6. Sendeanordnung nach Anspruch 4 oder 5, **dadurch gekennzeichnet, dass** die Photodiode (16) mit der Laserdiode (10) eine elektrische Rückkopplungsanordnung bildet.

7. Sendeanordnung nach Anspruch 6, **dadurch gekennzeichnet, dass** die Rückkopplungsanordnung einen Tiefpassfilter (18, 44) aufweist, der zwischen die Photodiode (16) und einen ersten Eingang (30) des ersten Verstärkers (12) geschaltet ist.

8. Sendeanordnung nach einem der vorhergehenden Ansprüche, **dadurch gekennzeichnet, dass** die Photodiode (16) mit einem Eingang (22) eines Referenzverstärkers (20) verbunden ist.

9. Sendeanordnung nach einem der vorhergehenden Ansprüche, **dadurch gekennzeichnet, dass** ein Lichtempfängeranordnung vorgesehen ist, welche an einem Objekt reflektiertes Licht der Laserdiode (10) empfängt.

10. Sendeanordnung nach Anspruch 9, **dadurch gekennzeichnet, dass** der Lichtempfängeranordnung ein Referenzsignal der Referenzverstärker (20) zuführbar ist.

11. Handwerkzeugmaschine, insbesondere Bohrmaschine, mit einer Sendeanordnung nach einem der vorhergehenden Ansprüche.

12. Entfernungsmessgerät mit einer Sendeanordnung nach einem der vorhergehenden Ansprüche.

13. Laser-Zeigergerät mit einer Sendeanordnung nach einem der vorhergehenden Ansprüche.
